# EUROPEAN PATENT APPLICATION

(11) **EP 2 146 561 A1**
(43) Date of publication of application: **20.01.2010**
(21) Application number: 09000585.1
(22) Date of filing: 16.01.2009
(51) Int. Cl.: H05K 3/42, H05K 3/00

(54) **Flexible film and display device including the same**

(30) Priority: 28.05.2008 KR 20080049495; 08.12.2008 KR 20080123830
(71) Applicant: LG Electronics Inc., Seoul 150-010 (KR)
(72) Inventor: Yum, Jungsup, Cheongju-si Chungcheongbuk-do 361-480 (KR); Ko, Dongki, Cheongju-si Chungcheongbuk-do 361-480 (KR)
(74) Representative: Katérle, Axel

(57) **Abstract**

A flexible film and a display device including the same are disclosed. The flexible film includes an insulating film and first and second metal layers on the insulating film. The insulating film including at least one hole, a first surface corresponding to an inner circumferential surface of the hole, a second surface corresponding to an upper surface of the insulating film, and a third surface corresponding to a lower surface of the insulating film. The first metal layer and the second metal layer are positioned on the first surface and at least one of the second and third surfaces. An angle between the first surface and the second surface is equal to or greater than an angle between the first surface and the third surface.

## Description

### BACKGROUND

### Field

Exemplary embodiments relate to a flexible film, and more particularly, to a flexible film used in various electrical devices.

### Description of the Related Art

A flexible film may be used in various electrical devices. As an example of the flexible film, there are a flexible printed circuit board (FPCB) and a flexible copper clad laminate (FCCL).

A metal layer of the FPCB or the FCCL is manufactured using a sputtering method, a casting method, or a laminating method.

In the sputtering method, a sputtering process is performed on a polyimide film to form a metal layer. In the casting method, liquid polyimide is coated on a metal thin film, and then a casting process is performed to thereby form a metal layer of the FCCL. In the laminating method, an adhesive is coated on a polyimide film, and a metal thin film is attached to the polyimide film using the laminating method.

In the sputtering method, because the surface of the polyimide film is damaged, the smoothness is reduced. In the casting method, kinds of usable polyimide films are limited. In the laminating method, it is not easy to manufacture the FPCB or the FCCL because of a limitation of physical properties of the used adhesive.

Accordingly, the FPCB or the FCCL with the improved physical properties, such as a peel strength has been recently demanded.

### SUMMARY

Exemplary embodiments provide a flexible film with excellent stability and reliability and a display device including the same.

In one aspect, there is a flexible film including an insulating film including at least one hole, a first surface corresponding to an inner circumferential surface of the hole, a second surface corresponding to an upper surface of the insulating film, and a third surface corresponding to a lower surface of the insulating film, and a first metal layer and a second metal layer on the insulating film, the first metal layer and the second metal layer being positioned on the first surface and at least one of the second and third surfaces, wherein an angle α between the first surface and the second surface is substantially equal to or greater than an angle β between the first surface and the third surface, wherein the angle α is an obtuse angle.

The angle β may be approximately 0.3 to 0.9 times the angle α.

The angle β may be approximately 0.8 to 0.9 times the angle α.

A diameter of the hole may be approximately 30 µm to 1,000 µm.

A thickness of the first metal layer may be approximately 0.02 µm to 0.2 µm.

The first metal layer may be an electroless plating layer.

The second metal layer may be an electrolytic plating layer.

The first metal layer may be formed of at least one selected from the group consisting of chromium (Cr), gold (Au), copper (Cu), and nickel (Ni), the first metal layer may include an upper layer formed of Cu and a lower layer formed ofNi.

The second metal layer may be formed of gold (Au) or copper (Cu).

A sum of a thickness of the first metal layer and a thickness of the second metal layer may be substantially equal to or greater than 3/1,000 and less than 1/2 of a diameter of the hole.

A sum of the thickness of the first metal layer and the thickness of the second metal layer may be approximately 1/100 to 1/10 of a diameter of the hole.

A ratio of a thickness of the first metal layer to a thickness of the second metal layer may be approximately 1:10 to 1:2,500.

A ratio of a thickness of the first metal layer to a thickness of the second metal layer may be approximately 1:400 to 1:500.

A flexible film includes a circuit pattern.

In another aspect, there is a display device including a display panel, a driver that applies a driving signal to the display panel, and a flexible film between the display panel and the driver, the flexible film including an insulating film including at least one hole, a first surface corresponding to an inner circumferential surface of the hole, a second surface corresponding to an upper surface of the insulating film, and a third surface corresponding to a lower surface of the insulating film, and a first metal layer and a second metal layer on the insulating film, the first metal layer and the second metal layer being positioned on the first surface and at least one of the second and third surfaces, wherein an angle α between the first surface and the second surface is substantially equal to or greater than an angle β between the first surface and the third surface, wherein the angle α is an obtuse angle.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:

FIG. 1 shows a flexible film according to an exemplary embodiment;

FIGs. 2 to 5 are cross-sectional views taken along line I-I' of FIG 1;

FIGs. 6 and 7 are cross-sectional views of a flexible film according to an exemplary embodiment taken along line I-I' of FIG 1; and

FIG. 8 is a perspective view of a display device according to an exemplary embodiment.

### DETAILED DESCRIPTION OF EMBODIMENTS

Reference will now be made in detail embodiments of the invention examples of which are illustrated in the accompanying drawings.

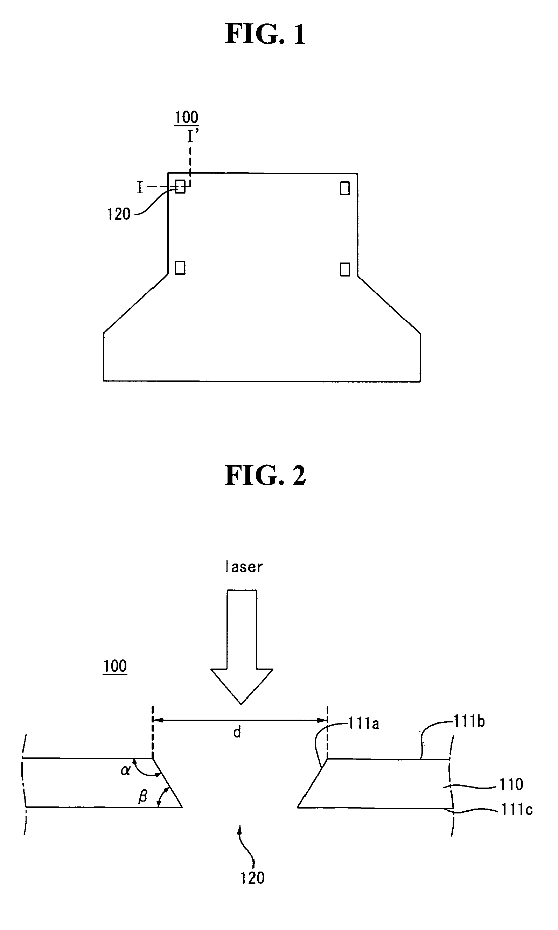

FIG. 1 shows a flexible film according to an exemplary embodiment, and FIGs. 2 to 5 are cross-sectional views taken along line I-I' of FIG 1.

As shown in FIGs. 1 to 5, a flexible film 100 may include an insulating film 110 including at least one hole 120 and first and second metal layers 131 and 132 on the insulating film 110. The insulating film 110 may include a first surface 111a corresponding to an inner circumferential surface of the hole 120, a second surface 111b corresponding to an upper surface of the insulating film 110, and a third surface 111 c corresponding to a lower surface of the insulating film 110. The first metal layer 131 and the second metal layer 132 may be positioned on the first surface 111a and at least one of the second and third surfaces 111b and 111c. In the flexible film 100, the first metal layer 131 and the second metal layer 132 may be positioned on the first, second and third surfaces 111a, 111b and 111c.

The insulating film 110 may be formed of one selected from the group consisting of polyester, polyimide, liquid crystal polymer, and fluorine resin. The insulating film 110 may be preferably formed of polyimide.

The insulating film 110 may have a thickness of approximately 12 µm to 50 µm and may have flexibility.

An angle α between the first surface 111a and the second surface 111b is substantially equal to or greater than an angle β between the first surface 111a and the third surface 111c.

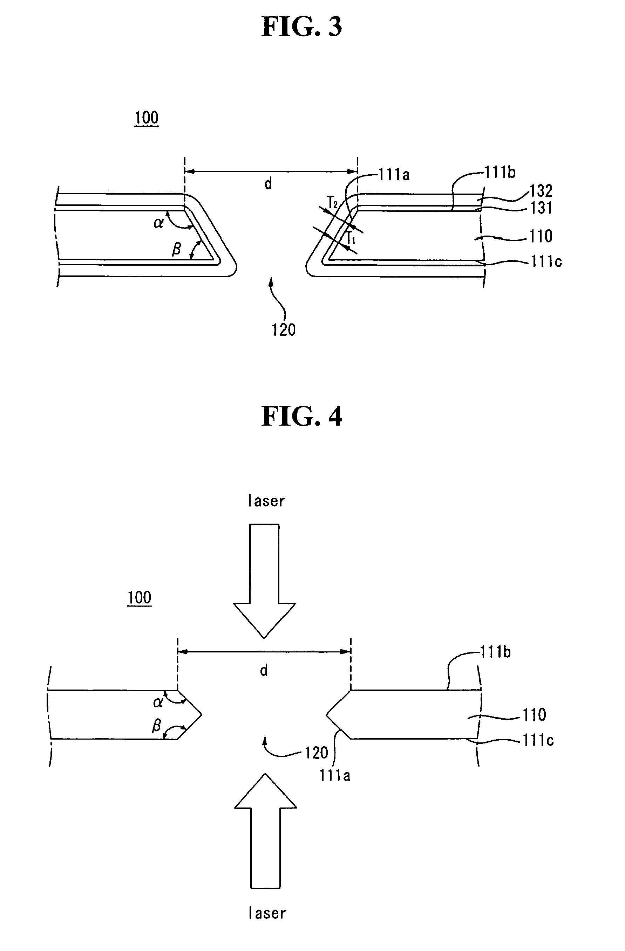

As shown in FIG 2, when the hole 120 is formed by irradiating a laser in a downward manner from the second surface 111b, the angle α between the first surface 111a and the second surface 111b may be greater than the angle β between the first surface 111a and the third surface 111c, and the angle α may be an obtuse angle. Accordingly, the flexible film 100 may have a structure shown in FIG. 3 by forming the first metal layer 131 and the second metal layer 132 on the insulating film 110.

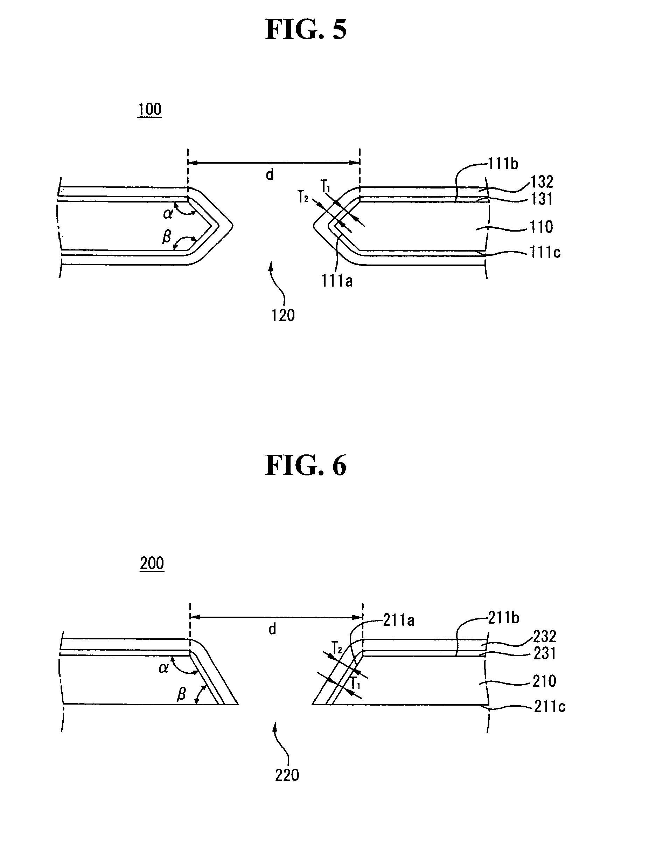

As shown in FIG 4, when the hole 120 is formed by irradiating the laser in an upward and downward manner from the second and third surfaces 111b and 111c, the angle α between the first surface 111a and the second surface 111b may be substantially equal to the angle β between the first surface 111a and the third surface 111c. Accordingly, the flexible film 100 may have a structure shown in FIG. 5 by forming the first metal layer 131 and the second metal layer 132 on the insulating film 110.

The following Table 1 shows a stability and a peel strength of the flexible film 100 depending on a ratio of the angle α to the angle β. In the following Table 1, ×, ○, and ⊚ represent bad, good, and excellent states of the characteristics, respectively.

**[Table 1]**

| α : β | **Stability** | **Peel strength** |
|---|---|---|
| 10:1 | × | × |
| 10:2 | × | × |
| 10:3 | ○ | ○ |
| 10:4 | ○ | ○ |
| 10:5 | ○ | ○ |
| 10:6 | ○ | ○ |
| 10:7 | ○ | ○ |
| 10:8 | ⊚ | ⊚ |
| 10:9 | ⊚ | ⊚ |
| 10:10 | ○ | ⊚ |
| 10:11 | × | ⊚ |

As indicated in Table 1, when the angle α is substantially equal to or greater than an angle β, a diameter of the hole 120 gradually widens as the hole 120 goes upward. Hence, the first metal layer 131 and the second metal layer 132 may be formed to have a constant thickness in a succeeding process, and thus the stability and the peel strength of the flexible film 100 may be improved.

The ratio of the angle α to the angle β may be approximately 10:3 to 10:9. When the ratio of the angle α to the angle β is equal to or greater than 10:3, the first metal layer 131 and the second metal layer 132 may be formed to have the constant thickness in the succeeding process, and thus the stability and the peel strength of the flexible film 100 may be good. When the ratio of the angle α to the angle β is equal to or smaller than 10:9, it is easy to form the first metal layer 131 and the second metal layer 132 on the first surface 111a.

The ratio of the angle α to the angle β may be approximately 10:8 to 10:9. When the ratio of the angle α to the angle β is 10:8 to 10:9, the stability and the peel strength of the flexible film 100 may be excellent as indicated in Table 1.

Accordingly, the angle β may be equal to and approximately 0.3 to 0.9 times the angle α The angle β may be approximately 0.8 to 0.9 times the angle α

The hole 120 is used to connect the flexible film 100 to electrodes or a circuit pattern of various electrical devices. The hole 120 may have a diameter d of approximately 30 µm to 1,000 µm. The diameter d of the hole 120 may be a distance between points where the first surfaces 111a meet the second surfaces 111b.

The first metal layer 131 may be formed of at least one selected from the group consisting of chromium (Cr), gold (Au), copper (Cu), and nickel (Ni) using an electroless plating method. Preferably, the first metal layer 131 may be formed of Ni or Cu with excellent electrical conductivity in consideration of process efficiency.

The first metal layer 131 may have a multi-layered structure formed of Ni and Cu. For example, a Ni layer may be formed on the insulating film 110 using the electroless plating method, and then a Cu layer may be formed on the Ni layer using the electroless plating method. Hence, an electroless plating layer having a two-layered structure may be formed. In other words, in the electroless plating layer having the two-layered structure, the Ni layer may be a lower layer and the Cu layer may be an upper layer. An electroless plating layer having a three-layered structure formed of Ni, Cu and Cu may be formed. Other multi-layered structures may be used.

Unlike the first metal layer 131, the second metal layer 132 may be formed of gold (Au) or copper (Cu) using an electrolytic plating method. Preferably, the second metal layer 132 may be formed of Cu in consideration of manufacturing cost.

A thickness T1 of the first metal layer 131 may be smaller than a thickness T2 of the second metal layer 132. More specifically, the first metal layer 131 may serve as a metal seed layer used to plate the second metal layer 132 and may be formed using the electroless plating method. Therefore, the thickness T1 of the first metal layer 131 may be very small and may is approximately 0.02 µm to 0.2 µm.

The second metal layer 132 may be formed on the entire surface of the first metal layer 131 using the electrolytic plating method. The thickness T2 of the second metal layer 132 thicker than the first metal layer 131 may be approximately 2 µm to 50 µm.

The second metal layer 132 on the first surface 111a may have a thickness of approximately 2 µm to 40 µm, and the second metal layer 132 on the second and third surfaces 111b and 111c may have a thickness of approximately 3 µm to 50 µm.

The following Table 2 shows a stability and a peel strength of the flexible film 100 depending on a ratio of the thickness T1 of the first metal layer 131 to the thickness T2 of the second metal layer 132. In the following Table 2, ×, ○, and ⊚ represent bad, good, and excellent states of the characteristics, respectively.

**[Table 2]**

| **T1:T2** | **Stability** | **Peel strength** |
|---|---|---|
| 1:5 | ○ | × |
| 1:10 | ○ | ○ |
| 1:50 | ○ | ○ |
| 1:100 | ○ | ○ |
| 1:400 | ⊚ | ⊚ |
| 1:500 | ⊚ | ⊚ |
| 1:1000 | ○ | ○ |
| 1:2000 | ○ | ○ |
| 1:2500 | ○ | ○ |
| 1:3000 | X | ○ |

As indicated in Table 2, the ratio of the thickness T1 to thickness T2 may be approximately 1:10 to 1:2,500. When the ratio of the thickness T1 to thickness T2 is equal to or less than 1/10, the electroless plating process for forming the first metal layer 131 may be performed within an appropriate period of time. Therefore, an accessory ingredient contained in a plating solution used in the electroless plating process may not reduce the peel strength of the surface of the first metal layer 131. When the ratio of the thickness T1 to thickness T2 is equal to or greater than 1/2,500, a formation material of the first metal layer 131 may be prevented from being substituted with tin (Sn) when circuit patterns are formed on the metal layers and a Sn layer is formed on the circuit patterns in a succeeding process.

The ratio of the thickness T1 to thickness T2 may be approximately 1:400 to 1:500. When the ratio of the thickness T1 to thickness T2 is 1:400 to 1:500, the stability and the peel strength of the flexible film 100 may be excellent as indicated in Table 2.

A sum of the thicknesses T1 and T2 of the first and second metal layers 131 and 132 may be substantially equal to or greater than 3/1,000 and less than 1/2 of the diameter d of the hole 120.

The following Table 3 shows a stability and a peel strength of the flexible film 100 depending on a ratio of the sum (T1+T2) of the thicknesses T1 and T2 of the first and second metal layers 131 and 132 to the diameter d of the hole 120. In the following Table 3, ×, ○, and ⊚ represent bad, good, and excellent states of the characteristics, respectively.

**[Table 3]**

| **(T1+T2) : d** | **Stability** | **Peel strength** |
|---|---|---|
| 1:1000 | × | × |
| 3:1000 | ○ | ○ |
| 1:500 | ○ | ○ |
| 1:300 | ○ | ○ |
| 1:100 | ⊚ | ⊚ |
| 1:50 | ⊚ | ⊚ |
| 1:10 | ⊚ | ⊚ |
| 1:5 | ○ | ○ |
| 1:2 | ○ | ○ |
| 1:1 | × | ○ |

As indicated in Table 3, the sum (T1+T2) of the thicknesses T1 and T2 of the first and second metal layers 131 and 132 may be substantially equal to or greater than 3/1,000 and less than 1/2 of the diameter d of the hole 120. When the sum (T1+T2) of the thicknesses T1 and T2 is equal to or greater than 3/1,000 of the diameter d of the hole 120, the metal layers each having a constant thickness may be formed on the insulating film 110. Hence, the stability of the flexible film 100 may be good. When the sum (T1+T2) of the thicknesses T1 and T2 is less than 1/2 of the diameter d of the hole 120, the hole 120 may be prevented from being filled with the thick metal layers.

The sum (T1+T2) of the thicknesses T1 and T2 of the first and second metal layers 131 and 132 may be approximately 1/100 to 1/10 of the diameter d of the hole 120. When the sum (T1+T2) of the thicknesses T1 and T2 is 1/100 to 1/10 of the diameter d of the hole 120, the stability and the peel strength of the flexible film 100 may be excellent as indicated in Table 3.

As described above, the stability of the flexible film 100 may be improved by adjusting the angel of the insulating film 110 and the thicknesses of the metal layers.

Further, the hole 120 may be prevented from being filled by adjusting the thicknesses of the metal layers. Hence, the excellent reliability of the connection between the flexible film 100 and the electrode may be secured. Accordingly, the flexible film 100 with the excellent stability and reliability may be provided.

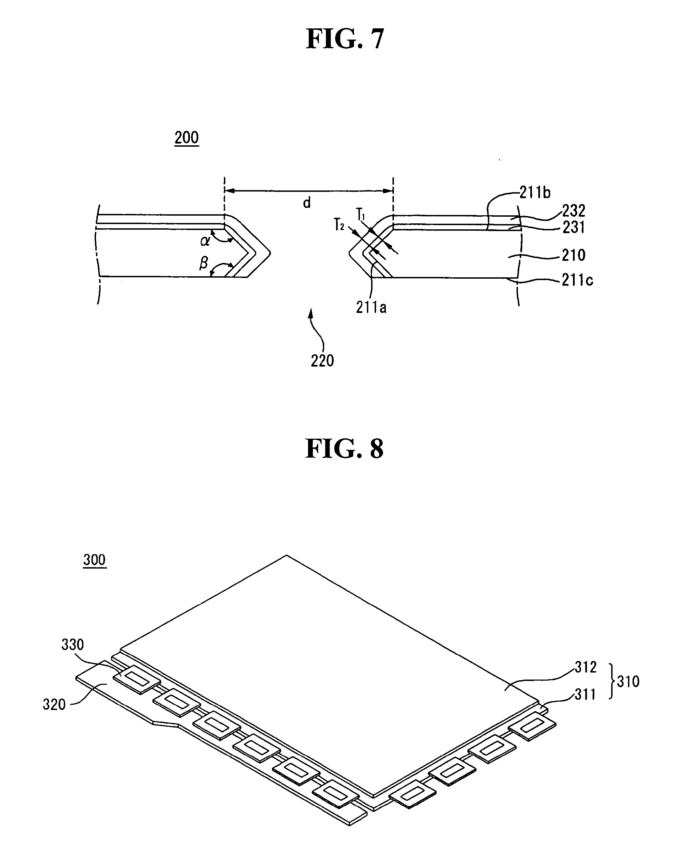

FIGs. 6 and 7 are cross-sectional views of a flexible film according to an exemplary embodiment taken along line I-I' of FIG. 1.

As shown in FIGs. 6 and 7, the flexible film 200 may include an insulating film 210 including at least one hole 220 and first and second metal layers 231 and 232 on the insulating film 210. The insulating film 210 may include a first surface 211 a corresponding to an inner circumferential surface of the hole 220, a second surface 211b corresponding to an upper surface of the insulating film 210, and a third surface 211 c corresponding to a lower surface of the insulating film 210. The first metal layer 231 and the second metal layer 232 may be positioned on the first surface 211 a and at least one of the second and third surfaces 211 b and 211c.

In the flexible film 200, the first metal layer 231 and the second metal layer 232 are positioned on the first surface 211 a and the second surface 211 b.

An angle β between the first surface 211 a and the third surface 211c may be approximately 0.3 to 0.9 times an angle α between the first surface 211 a and the second surface 211b.

As shown in FIG. 6, the angle α between the first surface 211a and the second surface 211b may be greater than the angle β between the first surface 211a and the third surface 211c. The angle α may be an obtuse angle.

As shown in FIG. 7, the angle α between the first surface 211 a and the second surface 211b may be substantially equal to the angle β between the first surface 211a and the third surface 211c.

A thickness T1 of the first metal layer 231 may be smaller than a thickness T2 of the second metal layer 232. More specifically, the first metal layer 231 may serve as a metal seed layer used to plate the second metal layer 232 and may be formed using an electroless plating method. Therefore, the thickness T1 of the first metal layer 231 may be very small and may is approximately 0.02 µm to 0.2 µm.

The second metal layer 232 may be formed on the entire surface of the first metal layer 231 using an electrolytic plating method. The thickness T2 of the second metal layer 232 thicker than the first metal layer 231 may be approximately 2 µm to 50 µm.

A ratio of the thickness T1 of the first metal layer 231 to the thickness T2 of the second metal layer 232 may be approximately 1:10 to 1:2,500. A sum (T1+T2) of the thickness T1 of the first metal layer 231 and the thickness T2 of the second metal layer 232 may be substantially equal to or greater than 3/1,000 and less than 1/2 of a diameter d of the hole 220. Because the flexible film was described in the above embodiment with reference to FIGs. 1 to 5, a description of the flexible film 200 is omitted in the present embodiment.

A method of manufacturing the flexible film according to the exemplary embodiments will be described below.

At least one hole is formed on an insulating film formed of polyimide. The hole is formed on a predetermined portion of the insulating film, and a diameter of the hole may be approximately 30 µm to 1,000 µm. The hole may be formed using one of a chemical etching method, a drilling method, and a laser processing method.

The insulating film may have a first surface corresponding to an inner circumferential surface of the hole, a second surface corresponding to an upper surface of the insulating film, and a third surface corresponding to a lower surface of the insulating film. An angle α between the first surface and the second surface may be substantially equal to or greater than an angle β between the first surface and the third surface.

In the related art, because the hole is formed after the metal layers are formed on the insulting film, an area of the hole has to be again plated with the metal layers. However, in the exemplary embodiments, because the metal layers are formed after the hole is formed on the insulting film, process time is reduced and it is easy to form the hole.

When a laser processing method is used to form the hole, the angle α between the first surface and the second surface may be different from the angle β between the first surface and the third surface depending on an irradiation direction of a laser irradiated on the insulating film. In particular, when the laser is irradiated in a downward manner from the second surface, the angle α may be an obtuse angle because of energy distribution of the laser.

Subsequently, a degreasing process is performed on the polyimide film on which the hole is formed. The degreasing process is a process for removing impurities on the surface of the polyimide film generated when the polyimide film is manufactured or processed. If the degreasing process is not performed, the peel strength of the flexible film may be reduced. An alkali rinse or a shampoo may be used as a degreasing solution in the degreasing process. Other materials may be used for the degreasing solution.

The degreasing process may be performed for about 5 minutes at a temperature of 20 °C to 30 °C. When a temperature of the degreasing process is equal to or higher than 20 °C, a reduction in activation of the degreasing solution may be prevented, and thus a degreasing effect may be improved. When a temperature of the degreasing process is equal to or lower than 30 °C, it is easy to adjust time required in the degreasing process.

A surface reforming process is performed on the surface of the polyimide film going through the degreasing process. The surface reforming process is a process for etching the surface of the polyimide film using an etching solution. The etching solution may use potassium hydroxide, a mixture of potassium hydroxide and ethylene glycol, a mixture of chromic acid and sulfuric acid. Other materials may be used for the etching solution.

The surface reforming process may be performed for about 5 to 10 minutes at a temperature of 40 °C to 50 °C. When a temperature of the surface reforming process is equal to or higher than 40 °C, an activation of the etching solution may be improved, and thus an etching effect may be improved. Further, because the surface reforming process is not performed for a long time because of an increase in the activation of the etching solution, the surface of the polyimide film may be prevented from being partially damaged. When a temperature of the surface reforming process is equal to or lower than 50 °C, it is easy to uniformly control the surface of the polyimide film because the etching operation is not rapidly performed.

The surface reforming process may increase an attachment between the polyimide film going through the surface reforming process and the first metal layer in a succeeding plating process. Hence, the peel strength of the flexible film may increase. An imide ring of the polyimide film is rearranged through the etching process and is substituted with amide group (-CONH) or carboxyl group (-COOH). Hence, the reactivity may increase.

A neutralization process is performed on the polyimide film going through the surface reforming process. An acid neutralization solution is used in the neutralization process when the etching solution used in the surface reforming process is an alkali solution. An alkali neutralization solution is used in the neutralization process when the etching solution is an acid solution.

The neutralization process is a process for substituting H⁺ ions of an acid solution for K⁺ or Cr³⁺ ions, that may remain by reacting on the amide group (-CONH) or the carboxyl group (-COOH) of the surface of the polyimide film obtained in the surface reforming process, to remove the K⁺ or Cr³⁺ ions.

If the K⁺ or Cr³⁺ ions remain on the surface of the polyimide film, the K⁺ or Cr³⁺ ions compare with coupling ions for polarizing the surface of the polyimide film in a succeeding polarizing process. Hence, the K⁺ or Cr³⁺ ions hinder the coupling ions from reacting on the amide group (-CONH) or the carboxyl group (-COOH).

The neutralization process may be performed at a temperature of 10 °C to 30 °C. When a temperature of the neutralization process is equal to or higher than 10 °C, a reduction in activation of a reaction solution may be prevented, and thus a neutralization effect may be improved. Further, the surface of the polyimide film may be prevented from being damaged. When a temperature of the neutralization process is equal to or lower than 30 °C, it is easy to control the uniformity of the polyimide film because a rapid reaction does not occur.

The neutralization process is not necessary, and may be selectively performed whenever necessary.

The polarizing process is performed on the polyimide film going through the neutralization process using a coupling solution.

The polarizing process is a process for polarizing the surface of the polyimide film by bonding the coupling ions in a portion of the polyimide film, in which the imide ring of the surface of the polyimide film is rearranged through the etching process. The polarizing process may allow a succeeding plating process to be smoothly performed and may improve the peel strength.

There may be a silane-based coupling agent or an amine-based coupling agent as the coupling solution usable in the polarizing process. Other materials may be used for the coupling agent.

The polarizing process may be performed at a temperature of 20 °C to 30 °C for 5 to 10 minutes.

Subsequently, the polyimide film going through the polarizing process is immersed in an acid solution at a normal temperature. Hence, the coupling ions, which are not bonded in a rearrangement area of the surface of the polyimide film, are removed.

The degreasing process, the surface reforming process, the neutralization process, and the polarizing process are preprocessing steps for performing the plating process, and the above-described preprocessing steps may increase the efficiency of the plating process.

A first metal layer is formed on the polyimide film going through the preprocessing steps using an electroless plating method. It is described in the exemplary embodiments that the electroless plating process is once performed to form the first metal layer. However, the electroless plating process may be twice performed to form the first metal layer having the multi-layered structure.

More specifically, a catalyst adding process is performed on the polyimide film going through the preprocessing steps. In the catalyst adding process, the polyimide film is immersed in a catalyst solution. Hence, palladium (Pd) as a catalyst may be adsorbed on the surface of the polyimide film. The catalyst solution used in the catalyst adding process may be a solution obtained by diluting PdCl₂ and SnCl₂ with hydrochloric acid in a volume ratio of 1:1.

If reaction time in the catalyst adding process is very short, an adsorption amount of Pd or Sn on the surface of the polyimide film may be reduced. If the reaction time is very long, the surface of the polyimide film may be corroded. Therefore, the reaction time is appropriately adjusted.

Then, the polyimide film going through the catalyst adding process is immersed in a plating solution, and the first metal layer is plated on the entire surface of the polyimide film.

The plating solution may include EDTA aqueous solution, caustic soda aqueous solution, copper sulfate plating solution obtained by mixing formalin aqueous solution with copper sulfate aqueous solution, or nickel sulfate plating solution obtained by mixing sodium hypophosphite, sodium citrate, ammonia, and nickel sulfate hexahydrate.

The plating solution may further include a small amount of polish component, a small amount of stabilizer component, and the like, to improve the physical properties of metal. The polish component and the stabilizer component may allow the plating solution to be recycled and to be preserved for a long time.

In case of using the copper sulfate plating solution, the polyimide film to which the catalyst is added is immersed in the copper sulfate plating solution at a temperature of 35 °C to 45 °C for 20 to 30 minutes without applying a current to the polyimide film to thereby form the first metal layer. As above, a method in which the plating process is performed without the current application is called an electroless plating method.

In case of using the nickel sulfate plating solution, the polyimide film to which the catalyst is added is immersed in the nickel sulfate plating solution at a temperature of 35 °C to 45 °C for 2 minutes to thereby form the first metal layer.

The process for forming the first metal layer is a preprocessing step for plating a second metal layer. The first metal layer having a thickness of 0.02 µm to 1 µm may be formed. The process for forming the first metal layer may be completely performed until a non-plated portion is removed from the polyimide film.

The polyimide film on which the first metal layer is formed is immersed in the plating solution, and then a current is applied to the polyimide film to form the second metal layer.

More specifically, the polyimide film on which the first metal layer is formed is immersed in the plating solution, and then a current of 2 A/d m² is applied to the polyimide film at a temperature of 40 °C to 50 °C for 30 minutes to form the second metal layer. Hence, the polyimide film including the second metal layer, for example, a flexible film printed circuit board (FPCB) or a flexible copper clad laminate (FCCL) is manufactured.

A concentration of the plating solution is held constant by smoothly stirring the plating solution. The plating conditions may be properly adjusted depending on a thickness of the plating layer to be obtained. As above, the plating process including the current application is called an electrolytic plating method.

As the usable plating solution, there are Enthone OMI on the market manufactured by Heesung Metal Ltd., NMP, and the like. A plating solution obtained by diluting a mixed solution of CuSO₄-H₂O, H₂SO₄, and HCl with water may be used. The plating solution may further include a small amount of polish component and a small amount of stabilizer component.

After a plating state of the FPCB or the FCCL manufactured through the above-described processes is evaluated to the naked eye, the flexible film according to the exemplary embodiments may be completed.

A circuit pattern may be printed on the flexible film according to the exemplary embodiments. The flexible film on which the circuit pattern is printed may be connected to electrodes or circuit patterns of various electrical devices to transmit electrical signals to the various electrical devices.

FIG. 8 is a perspective view of a display device according to an exemplary embodiment.

As shown in FIG. 8, a display device 300 may include a display panel 310, a driver 320 applying a driving signal to the display panel 310, a flexible film 330 between the display panel 310 and the driver 320.

The display device 300 may be a flat panel display, such as a liquid crystal display (LCD), a plasma display panel (PDP), and an organic light emitting display device.

The display panel 310 may include a first substrate 311 and a second substrate 312. The first substrate 311 may include a plurality of pixels. The pixels may be arranged in a matrix format to display an image. A plurality of electrodes connected to the driver 320 may be arranged in the pixels to cross each other. For example, a first electrode may be arranged in a horizontal direction, and a second electrode may be arranged in a direction perpendicular to the first electrode. The second substrate 312 may be a transparent glass substrate sealing the first substrate 311.

The driver 320 may apply signals to the electrodes to thereby display the image on the display panel 310.

The flexible film 330 may be connected between the display panel 310 and the driver 320 to transmit the signals generated by the driver 320 to the display panel 310. The flexible film 330 may be a film with flexibility on which a predetermined circuit pattern is printed. The flexible film 330 may include an insulating film, metal layers on the insulating film, a circuit pattern on the metal layers, an integrated circuit (IC) chip connected to the circuit pattern, and the like.

The flexible film 330 may include an insulating film including at least one hole, a first surface corresponding to an inner circumferential surface of the hole, a second surface corresponding to an upper surface of the insulating film, and a third surface corresponding to a lower surface of the insulating film, and a first metal layer and a second metal layer on the insulating film. The first metal layer and the second metal layer may be positioned on the first surface and at least one of the second and third surfaces. An angle α between the first surface and the second surface may be substantially equal to or greater than an angle β between the first surface and the third surface, and may be an obtuse angle.

Accordingly, the display device according to the exemplary embodiment may provide the excellent reliability by including the flexible film according to the exemplary embodiments.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A flexible film comprising:
an insulating film including at least one hole, a first surface corresponding to an inner circumferential surface of the hole, a second surface corresponding to an upper surface of the insulating film, and a third surface corresponding to a lower surface of the insulating film; and
a first metal layer and a second metal layer on the insulating film, the first metal layer and the second metal layer being positioned on the first surface and at least one of the second and third surfaces,
wherein an angle α between the first surface and the second surface is substantially equal to or greater than an angle β between the first surface and the third surface,
wherein the angle α is an obtuse angle.

2. The flexible film of claim 1, wherein the angle β is approximately 0.3 to 0.9 times the angle α.

3. The flexible film of claim 2, wherein the angle β is approximately 0.8 to 0.9 times the angle α.

4. The flexible film of claim 1, wherein a diameter of the hole is approximately 30 µm to 1,000 µm.

5. The flexible film of claim 1, wherein a thickness of the first metal layer is approximately 0.02 µm to 0.2 µm.

6. The flexible film of claim 1, wherein the first metal layer is an electroless plating layer.

7. The flexible film of claim 1, wherein the second metal layer is an electrolytic plating layer.

8. The flexible film of claim 1, wherein the first metal layer is formed of at least one selected from the group consisting of chromium (Cr), gold (Au), copper (Cu), and nickel (Ni),
wherein the first metal layer includes an upper layer formed of Cu and a lower layer formed of Ni.

9. The flexible film of claim 1, wherein the second metal layer is formed of gold (Au) or copper (Cu).

10. The flexible film of claim 1, wherein a sum of a thickness of the first metal layer and a thickness of the second metal layer is substantially equal to or greater than 3/1,000 and less than 1/2 of a diameter of the hole.

11. The flexible film of claim 1, wherein a sum of the thickness of the first metal layer and the thickness of the second metal layer is approximately 1/100 to 1/10 of a diameter of the hole.

12. The flexible film of claim 1, wherein a ratio of a thickness of the first metal layer to a thickness of the second metal layer is approximately 1:10 to 1:2,500.

13. The flexible film of claim 12, wherein a ratio of a thickness of the first metal layer to a thickness of the second metal layer is approximately 1:400 to 1:500.

14. The flexible film of the claim 1, wherein the flexible film includes a circuit pattern.

15. A display device comprising the flexible film as per claim 1, further comprising a driver and a display panel.
